# EUROPEAN PATENT SPECIFICATION

(11) **EP 3 104 406 B1**
(45) Date of publication and mention of the grant of the patent: **03.04.2019**
(21) Application number: 15743322.8
(22) Date of filing: 02.02.2015
(51) Int. Cl.: H01L 23/373

(54) **POWER MODULE**
LEISTUNGSMODUL
MODULE DE PUISSANCE

(30) Priority: 03.02.2014 JP 2014018592
(43) Date of publication of application: 14.12.2016
(73) Proprietor: Denka Company Limited, Tokyo 103-8338 (JP)
(72) Inventor: KINO Motonori, Omuta-shi Fukuoka 836-8510 (JP); HIROTSURU Hideki, Omuta-shi Fukuoka 836-8510 (JP); MIYAKAWA Takeshi, Omuta-shi Fukuoka 836-8510 (JP)
(74) Representative: Beckmann, Claus
(86) International application number: PCT/JP2015/052880
(87) International publication number: WO 2015/115649

(56) References cited:
- JP-A- 2000 281 468
- JP-A- 2001 291 809
- US-A1- 2009 280 351

## Description

### TECHNICAL FIELD

The present invention relates to a power module comprising a high-thermal-conductivity silicon carbide complex material that has excellent thermal conductivity properties, is lightweight, and is suitable for use as a heat dissipating member such as a heat sink in semiconductor components such as ceramic substrates and IC packages, and a method for manufacturing the same.

### BACKGROUND ART

In recent years, with the increasing capacity of semiconductor devices and higher integration of semiconductor devices in the semiconductor field, the issue of how to efficiently dissipate thermal energy generated by semiconductor devices to the outside has gained importance. Semiconductor devices are normally used by mounting them on insulating substrates such as ceramic substrates. In that case, the operating properties of the semiconductor devices are ensured by dissipating heat generated by semiconductor devices to the outside through heat dissipating components known as heat sinks which are provided on the back surfaces of substrates or the like.

Conventionally, copper (Cu) has mainly been used as the material for these heat sinks. Copper has a high thermal conductivity of 390 W/mK near room temperature, but also has a large coefficient of thermal expansion of 17 × 10⁻⁶/K, and the thermal expansion difference between the ceramic substrate (coefficient of thermal expansion: 7 to 8 × 10⁻⁶/K) and the heat sink can cause cracking or breaking of the ceramic substrate due to the load from thermal cycling and thermal joining. Conventionally, when using a ceramic substrate as a heat dissipating component in a field requiring reliability, Mo, W or the like, for which the difference in coefficient of thermal expansion with respect to ceramic substrates is small, has been used as heat sinks.

The heat sinks composed of Mo or W mentioned above, while having excellent reliability, are problematic in terms of their heat dissipation properties, having low thermal conductivities of 150 W/mK, and furthermore, such heat sinks are expensive. In view of these circumstances, in recent years, metal-ceramic composites, abbreviated as MMC (Metal Matrix Composite), which are copper or aluminum alloys reinforced with inorganic fibers or particles, have received attention. Such composites are generally composites wherein a preform is formed by pre-molding inorganic fibers or particles which are reinforcing materials, and causing a metal which is a base material to infiltrate between the fibers or particles of the preform. As the reinforcing materials, ceramics such as alumina, silicon carbide, aluminum nitride, silicon nitride, silica and carbon are used. However, reaction layer of the interface, the wettability between the ceramic which is the reinforcing material and the alloy which is the base material, and similar factors also largely contribute to the thermal conductivity.

In the above-mentioned composite, when the thermal conductivity is to be raised, substances with high thermal conductivity must be chosen as the reinforcing material and the alloy, and in order to lower the coefficient of thermal expansion, a reinforcing material with a low coefficient of thermal expansion must be chosen. For this reason, research has focused on silicon carbide-aluminum alloy composites.

EP 1 000 915 A2 describes a silicon carbide composite which is a flat composite comprising a porous preform of silicon carbide and a metal containing aluminum as the main component, infiltrated into the porous preform, said composite having a warpage of at most 250 µm per 10 cm of the principal plane length of the composite.

US 2009/280351 A1 describes an aluminum-silicon carbide composite suitable for a base plate for power module. In particular, the document describes a base plate for a power module, comprising an aluminum-silicon carbide composite that is a flat plate-shaped silicon carbide porous body impregnated with a metal containing aluminum as the main component, and an aluminum layer made of a metal containing aluminum as the main component formed only on one of the principal planes of the composite, wherein a rear surface being the other one of principal planes of the aluminum-silicon carbide composite is exposed to the outside, and the shape of the exposed aluminum-silicon carbide composite is a rectangle or a rectangle from which portions encompassing holes in the peripheral portion are removed.

### PRIOR ART DOCUMENTS

### PATENT DOCUMENTS

Patent Document 1: JP 3468358 B
Patent Document 2: JP H5-507030 A
Patent Document 3: JP H9-157773 A
Patent Document 4: JP H10-335538 A

### SUMMARY OF INVENTION

### PROBLEMS TO BE SOLVED BY THE INVENTION

However, in a conventional heat dissipating component having a joint structure between a ceramic substrate and a heat sink as mentioned above, when a heavy metal material such as Mo or W is used as the heat sink, there are problems in that the weight of the heat dissipating component becomes heavy, and the heat dissipation ability is not always sufficient. On the other hand, when Cu, Al or the like, which are relatively lightweight and have excellent heat dissipation ability, are used as heat sinks, there are problems in that the thermal expansion difference with the ceramic substrate is large and the joint structure itself must be made extremely complicated in order to obtain a highly reliable structure, resulting in increased production costs and increased thermal resistance as heat dissipation components. For these reasons, in conventional heat dissipating components having a joint structure between a ceramic substrate and a heat sink, simplification of the joint structure and improvement of the reliability and heat dissipation ability are sought.

On the other hand, in order to solve the above-mentioned problems, metal-ceramic composites have been considered, but when trying to obtain a coefficient of thermal expansion close to that of a ceramic substrate, the proportion of the ceramics which are the reinforcing materials having a low coefficient of thermal expansion must be raised. In order to raise the proportion of the ceramic component, the preform must be molded using a high molding pressure, which has the problem of leading to increased cost and making the subsequent impregnation of sufficient alloy difficult. For this reason, the development of a technology capable of inexpensively providing a metal-ceramic composite having a coefficient of thermal expansion close to that of a ceramic substrate and having a high thermal conductivity is sought.

Furthermore, such a composite, when used as a heat dissipating component, is used by soldering to a circuit board, and if the composite is warped too much, soldering can be difficult. For this reason, when using such a composite as a heat dissipating component, the amount of warpage must be controlled to be a predetermined amount or less. On the other hand, components such as power modules incorporating such heat dissipating components are generally used by screwing them onto heat dissipating fins or the like. In that case, in order for stress to act on the joint surface between a component such as a power module and a heat dissipating fin, it is preferable, for purposes of heat dissipation, for the joint surface to be convex, since this makes the clamping force larger after screw-fastening. However, in conventional metal-ceramic composites, when wishing to optionally introduce a shape such as warpage in this way, there have been no methods for doing so except by adjustment by post-processing. In that case, there are problems in that metal-ceramic composites are extremely hard, so their processing costs are high and the component itself becomes extremely expensive.

The present invention has been made in consideration of the above-described circumstances, and has the purpose of inexpensively providing a composite that has high thermal conductivity, a low specific gravity, a coefficient of thermal expansion close to that of a ceramic substrate, and having warpage so as to be able to be joined with good closeness of contact to a heat dissipating component or the like, and a heat dissipating component using the same.

### MEANS FOR SOLVING THE PROBLEMS

As a result of performing diligent research in order to achieve the above-mentioned purpose, the present inventors discovered that the properties such as the coefficient of thermal expansion and the shape of a composite can be controlled by adjusting the composition of the composite and the structure thereof, thereby completing the present invention.

The present invention provides the power module according to claim 1 and the method of manufacturing the power module according to claim 6. Preferred embodiments of the invention are defined in the dependent claims. In other words, the present invention employs a plate-shaped composite formed by pressure impregnation of a porous silicon carbide molded article with a metal containing aluminum, the silicon carbide composite having a plate thickness t of 2 mm to 6 mm and an in-plane thickness variation within t ± 0.3 mm.

Additionally, the silicon carbide composite has four or more hole portions for screw-fastening another heat dissipating component in the plane of the plate-shaped composite so as to face a convex surface of the plate-shaped composite, wherein an amount of warpage (Cx; µm) with respect to 10 cm of length in an inter-hole direction (X direction) and an amount of warpage (Cy; µm) with respect to 10 cm of length in a direction (Y direction) perpendicular thereto have the relationships 50 ≤ Cx ≤ 250 and 0 ≤ Cy ≤ 200, and an amount of warpage of the power module using the plate-shaped composite is 50 ≤ Cx ≤ 250 and 0 ≤ Cy ≤ 200.

Furthermore, in a preferred embodiment, the present invention employs a silicon carbide composite wherein front and back surfaces of the plate-shaped composite are both covered by a metal layer containing aluminum having an average thickness of 10 to 110 µm as the main component, and the difference in average thickness between the front and back metal layers is 100 µm or less.

Additionally, in a preferred embodiment, the present invention employs a silicon carbide composite wherein the plate-shaped composite consists of a composite portion (A), and a metal layer (B) provided on at least one surface of the composite and having aluminum as the main component, and the ratio (TA/TB) between the average value (TA; µm) of the thickness of the composite portion (A) and the sum (TB; µm) of the average values of the thicknesses of the metal layers (B) on both surfaces is 10 to 30.

Furthermore, in a preferred embodiment, the present invention employs a silicon carbide composite wherein the amount of warpage with respect to 10 cm of length of the main surface of the composite is 50 to 250 µm, and the product of the maximum length (L; cm) of the composite and the absolute value (|TB1 - TB2|) of the difference between the average value (TB1; µm) of the thickness of the metal layer (B) on the front surface and the average value (TB2; µm) of the thickness on the back surface is at least 500 and at most 2000.

Additionally, in the method for manufacturing a power module according to the present invention, the silicon carbide composite is warped by plastic deformation by applying stress at a temperature of at least 350 °C.

Furthermore, in a preferred embodiment, the present invention employs a silicon carbide composite wherein the average coefficient of thermal expansion when heated from room temperature (25 °C) to 150 °C is at most 9 × 10⁻⁶/K, and the thermal conductivity at room temperature (25 °C) is at least 150 W/mK.

Furthermore, in a preferred embodiment, the present invention provides a power module comprising a heat dissipating component formed by joining, to the plate-shaped composite, a ceramic substrate for mounting a semiconductor.

Additionally, in a preferred embodiment of the present invention, the ceramic substrate is composed of aluminum nitride and/or silicon nitride.

Furthermore, in a preferred embodiment, the power module comprises a heat dissipating component wherein, when the surface that is not joined to the ceramic substrate is attached to a flat plate with a heat dissipating grease provided therebetween, at least 90% of the surface closely contacts the flat plate under conditions of a tightening torque of at least 2 N.

### EFFECTS OF THE INVENTION

Since the composite used according to the present invention is formed by impregnating a silicon carbide porous body with a metal containing aluminum, the composite has the characteristics of being able to reduce the processing cost, having high thermal conductivity, having an average coefficient of thermal expansion close to that of a ceramic substrate, and being lightweight. By forming a heat dissipating component used by joining with a ceramic substrate for mounting a semiconductor, a heat dissipating component having excellent reliability that is suitable for mobile equipment or the like in electric automobiles or the like can be provided inexpensively. Additionally, the composite used according to the present invention has a specific amount of warpage, and for example, when used as a heat dissipating plate, allows a ceramic substrate to be screw-fastened with good closeness of contact to heat dissipating components such as heat dissipating fins, so the heat dissipating ability is made stable. Therefore, the invention has the effect of allowing a highly reliable module to be formed, and is extremely useful for industrial purposes.

### MODES FOR CARRYING OUT THE INVENTION

The coefficient of thermal expansion of a metal-ceramic composite is normally determined by the content ratio between the ceramic which is the reinforcing material and the metal which is the base material. The coefficients of thermal expansion of ceramics are much lower than the coefficients of thermal expansion of metals, so increasing the proportion of ceramics is effective in lowering the coefficient of thermal expansion of composites. On the other hand, the thermal conductivity of a metal-ceramic composite is basically also determined by the content ratio between the ceramic which is the reinforcing material and the metal which is the base material, but in the case of thermal conductivity, the bonding state at the interface between the reinforcing material and the base material contributes significantly. Between ceramics and metals, the thermal conductivity of metals is generally higher, but silicon carbide (SiC), aluminum nitride (AlN), boron nitride (BN) and the like have a theoretical thermal conductivity equivalent to or greater than that of metals (300 W/mK or more), so they are extremely promising as reinforcing materials for raising the thermal conductivity. However, when actually producing a composite, AIN and BN are expensive, which makes the resulting composite expensive as well. Additionally, AlN and BN easily oxidize in an air atmosphere, and when used to form composites, tend to form a glass phase with extremely low thermal conductivity between the ceramic which is the reinforcing material and the metal which is the base material, and as a result, the thermal conductivity of the obtained composite is lowered.

As a result of various studies regarding reinforcing materials, the present inventors discovered that ceramics that have silicon carbides as their main component are suitable for producing metal-ceramic composites having both high thermal conductivity and a low coefficient of thermal expansion.

On the other hand, when producing such a composite, the wettability between the reinforcing material and the metal becomes important in order to obtain a dense composite. If the melting point of the impregnated metal is high, the temperature will be high at the time of impregnation, and this can cause the ceramic to oxidize, or the ceramic and metal to react and form compounds with undesirable properties. Furthermore, if the melting point of the metal which is the base material is high, the impregnation temperature becomes high, limiting the materials that can be used for the mold elements or the like, and also increasing the casting cost, making the obtained composite expensive.

As a result of various studies regarding the metal which is the base material, the present inventors discovered that a good composite can be produced by using an alloy having aluminum as the main component. In other words, the composite used according to the present invention is obtained by impregnating a silicon carbide powder or a silicon carbide porous body with a metal having aluminum as the main component.

The properties such as the coefficient of thermal expansion and thermal conductivity of the metal-ceramic composite are determined by the properties of the ceramic which is the reinforcing material and the metal which is the base material, and their content ratio. The silicon carbide content in the composite used according to the present invention is preferably 50 to 80 vol%, and more preferably 60 to 70 vol%. If the silicon carbide content is less than 50 vol%, the coefficient of thermal expansion of the composite becomes high and the highly reliable heat dissipating component which is the objective of the present invention cannot be obtained. Additionally, while a high silicon carbide content is effective for obtaining high thermal conductivity and a low coefficient of thermal expansion in the composite, if filled in excess of 80 vol%, there are problems such as the need for an extremely high molding pressure, and the cost of the resulting metal-ceramic composite becomes extremely high.

On the other hand, the metal in the silicon carbide composite used according to the present invention is an alloy having aluminum as the main component, preferably containing at most 20 mass% of silicon and at most 5 mass% of magnesium. Regarding metal components other than aluminum, silicon or magnesium in the alloy, copper or the like can also be included if within a range that does not extremely change the properties of the alloy. By adjusting the components other than the aluminum in the alloy, the thermal conductivity and coefficient of thermal expansion of the alloy itself can be changed, and the coefficient of thermal expansion and thermal conductivity of the resulting composite may also be adjusted. Additionally, due to the formation of an alloy of an aluminum metal with silicon or magnesium, the melting point of the alloy is lowered and the viscosity of the molten metal at high temperatures is reduced, making it easier to obtain a dense composite with a high-temperature casting method or the like. Furthermore, by forming an alloy of aluminum metal, the hardness of the metal itself is increased, as a result of which the mechanical properties such as the strength of the resulting composite are also improved.

Additionally, the silicon carbide composite used according to the present invention is characterized by having a plate thickness t of 2 mm to 6 mm, and an in-plane thickness variation within t ± 0.3 mm. If the plate thickness is less than 2 mm, when used as a heat dissipating component, the heat dissipating ability in the planar direction of the silicon carbide composite is lowered, and the heat dissipating ability of the heat dissipating component is undesirably lowered. On the other hand, if the plate thickness exceeds 6 mm, the thermal resistance of the silicon carbide composite itself becomes large, and the heat dissipating ability of the heat dissipating component is undesirably lowered. Additionally, if the in-plane thickness variation lies outside the range of t ± 0.3 mm, when components such as power modules incorporating heat dissipating components comprising the silicon carbide composite are used by screwing them onto heat dissipating fins or the like, air gaps will be formed at the joint surfaces between the components such as power modules and the heat dissipating fins, thereby undesirably reducing the heat dissipating ability. The expression "an in-plane thickness variation within t ± 0.3 mm" means that if the thickness of the composite is measured at multiple locations and the average thickness of the composite is calculated from the average value thereof and set as 0, then the maximum value and minimum value will fall within ± 0.3 mm.

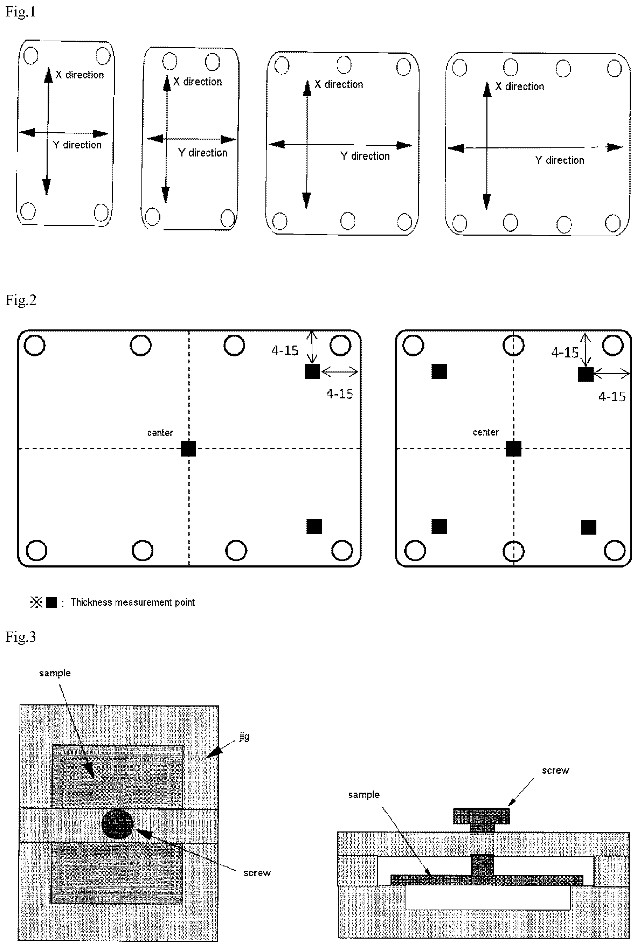

Additionally, essential to the present invention is that the warpage amount is 250 µm or less with respect to 10 cm of length of the main surface of the composite. If the warpage amount exceeds 250 µm with respect to 10 cm of length of the main surface of the composite, when using the composite as a heat dissipating component, there are problems such as joining defects occurring with circuit boards or the like, or excessive bending stress being applied when screw-fastening heat dissipating fins or the like, resulting in damage to the composite. On the other hand, components such as power modules incorporating heat dissipating components comprising such composites are used by screw-fastening them to heat dissipating fins or the like. In that case, in order for stress to act on the joint surface between the components such as power modules and heat dissipating fins, it is preferable in terms of heat dissipation for the joint surface to be convex, so that the clamping force after screw-fastening is large. The convex surface may be formed by making use of the warpage that occurs when producing the composite, or formed by forcibly warpage using a jig as shown in Fig. 3.

The power module of the present invention has four or more hole portions so as to allow other heat dissipating components to be screw-fastened within the main surface of the plate-shaped composite. Regarding the shapes of the holes, they may be appropriately chosen depending on the size of the heat dissipating component or the like, but a size allowing penetration of an M6 to M10 screw will generally be satisfactory. Regarding the number of holes, many may be provided such as four or more depending on the heat dissipating plate, but if there are three or less, the entire surface of the heat dissipating plate may not be able to be made to closely contact the other heat dissipating components. While the hole formation locations may be chosen on a discretionary basis, they could, for example, be formed at the four corners of the plate-shaped composite.

Essential to the present invention is that the amount of warpage (Cx; µm) with respect to 10 cm of length in the inter-hole direction (X direction) and the amount of warpage (Cy; µm) with respect to 10 cm of length in the direction (Y direction) perpendicular to the X direction have the relationships 0 ≤ Cx ≤ 250 and also 0 ≤ Cy ≤ 300. Additionally, when the warpage amounts (Cx; µm and Cy; µm) are within the specific ranges mentioned above, the amount of warpage of a power module using the plate-shaped composite becomes 50 ≤ Cx ≤ 250 and 0 ≤ Cy ≤ 200. In general, the inter-hole direction (X direction) refers to one direction on the surface of the heat dissipating plate as shown in Fig. 1(a) to (d), and the Y direction refers to the direction within the surface perpendicular to the X direction.

The present inventors experimentally considered many possibilities in an attempt to solve the aforementioned problems in the conventional art, as a result of which they discovered that a heat dissipating plate composed of a composite can be screw-fastened to another heat dissipating component with good closeness of contact when the amounts of warpage (Cx; µm and Cy; µm) are within the aforementioned specific ranges, thereby arriving at the present invention. When screw-fastening a heat dissipating plate composed of the composite used according to the present invention to another heat dissipating component with good closeness of contact, they will generally be fastened by providing heat dissipating grease or the like between the heat dissipating plate and the heat dissipating component. For this reason, the absolute value of the warpage amount (Cy) in the Y direction is preferably smaller than the thickness of the heat dissipating grease. Additionally, when considering the deformation of the heat dissipating plate during tightening, the warpage amount (Cy) in the Y direction should preferably smaller than the warpage amount (Cx) in the X direction. When the aforementioned warpage amounts cannot satisfy the aforementioned specific ranges, the heat dissipating plate may not always be able to be screw-fastened to other heat dissipating components with good closeness of contact.

Additionally, in a preferred embodiment of the of the present invention, a plate-shaped composite is formed by joining an alloy layer (B) having aluminum as the main component on both surfaces of a plate-shaped composite (A). Due to the surface portion being covered by an alloy layer having aluminum as the main component, when processing the surface portion, it is sufficient to process this metal portion, and the load at the time of processing can be significantly reduced. This is because, if there is a metal-ceramic composite at the surface portion, just that part will be hard, and the processing will be uneven, or expensive processing tools such as diamonds or the like will be needed. Additionally, due to the surface portion being a metal layer, the uniformity is improved when performing a plating process. For the above reasons, the average thickness of the metal layer is chosen to be at least 10 µm.

On the other hand, since the metal layer consists of a metal having aluminum as the main component, the coefficient of thermal expansion is high compared to the metal-ceramic composite portions. Therefore, if the thickness of the metal layer increases, the coefficient of thermal expansion of the composite overall becomes large, and the average thickness of the metal layer is chosen to be 110 µm or less.

Additionally, if there is a difference in the average thicknesses of the front and back metal surfaces, then differences in the coefficient of thermal expansion between the metal layer and the metal-ceramic composite may cause differences in the thermal expansion of the front and back surfaces of the composite itself, as a result of which the composite can be warped. Such warpage, if not controlled, can cause joint defects with circuit boards or the like when using the composite as a heat dissipating component or the like. There is a close relationship between the warpage amount and the thickness difference between the front and back metal layers, such that if the thickness difference exceeds 110 µm, the warpage of the composite becomes too large, and is no longer suitable for use as a heat dissipating component or the like. Additionally, when the main surface of the plate-shaped composite has hole portions so as to allow screw-fastening to other heat dissipating components, if the distance between holes is compact, i.e. 10 cm or less, then in order to screw-fasten the heat dissipating plate to other heat dissipating components with good closeness of contact, the warpage amount should preferably be 100 µm or less with respect to 10 cm of length of the main surface of the composite.

Furthermore, in a preferred embodiment of the present invention the ratio (TA/TB) between the average value (TA) of the thickness of the plate-shaped composite (A) and the sum (TB) of the average values of the thicknesses of the front and back alloy layers is 5 to 30, preferably 10 to 30. If TA/TB is less than 5, the alloy layers on the surfaces become too thick, and the properties such as the coefficient of thermal expansion and the thermal conductivity are reduced. On the other hand, if TA/TB exceeds 30, the alloy layers on the surface become too thin, so that when performing mechanical processing or the like of the surface portion, the plate-shaped composite may be partially exposed, causing problems such as damaging processing tools, or reducing the plating properties. Additionally, the alloy layer must have a certain thickness when adjusting the thickness of the surface alloy layers in order to adjust the shape, specifically the warpage amount, of the composite, so TA/TB must be 30 or less.

Additionally, the warpage amount with respect to 10 cm of length of the main surface of the composite should be 50 to 250 µm, and the maximum length (L; cm) of the composite and the difference between the average value (TB1; µm) of the thickness of the alloy layer (B) on the front side and the average value (TB2; µm) of the thickness on the back side should satisfy the relationship 500 < (TB1 - TB2) × L < 2500, preferably 500 < (TB1 - TB2) × L ≤ 2000. If the amount of warpage with respect to 10 cm of length in the main surface of the composite exceeds 250 µm, when using the composite as a heat dissipating component, problems tend to occur, such as joint defects occurring with circuit boards or the like, and excessive bending stress being applied when screw-fastening heat dissipating fins or the like and causing damage to the composite. On the other hand, components such as power modules incorporating heat dissipating components composed of such a composite can be used by screw-fastening them to heat dissipating fins or the like. In that case, in order for stress to act on the joint surfaces between components such as power modules and heat dissipating fins, it is preferable, for purposes of heat dissipation, for the joint surface to be convex so that the clamping force after screw-fastening is large. For this reason, if the warpage amount with respect to 10 cm of length in the main surface of the composite is less than 50 µm, the amount of warpage when used as a heat dissipating component or the like can be insufficient, and problems in the heat dissipation properties may occur.

In a composite of this structure, if there are differences in the thickness of the front and back alloy layers due to differences in the coefficient of thermal expansion between the alloy layer and the plate-shaped composite (metal-ceramic composite), there will be differences in thermal expansion between the front and back of the composite itself, as a result of which warpage will occur in the composite. Such warpage is closely related to the thickness difference between the front and back alloy layers and the size of the plate-shaped composite, and it becomes greater as the thickness difference between the front and back alloy layers increases, and as the size of the plate-shaped composite becomes larger. If (TB1 - TB2) × L exceeds 2500, the warpage amount of the composite becomes too large, and if (TB1 - TB2) × L is less than 500, the warpage amount of the composite becomes too small, and undesirably, problems such as described above will occur when used as a heat dissipating component.

As the amount of warpage of the composite, a warpage amount of 50 to 250 µm with respect to 10 cm of length in the main surface of the composite is preferable. If the warpage amount exceeds 250 µm with respect to 10 cm of length in the main surface of the composite, when the composite is used as a heat dissipating component, problems may occur, such as joint defects with circuit boards or the like, and excessive bending stress being applied when screw-fastening to heat dissipating fins or the like, causing damage to the composite. On the other hand, components such as power modules incorporating heat dissipating components composed of such a composite can be used by screw-fastening to heat dissipating fins or the like. In that case, in order for stress to act on the joint surface between components such as power modules and heat dissipating fins, it is preferable, for purposes of heat dissipation, for the joint surface to be convex so that the clamping force after screw-fastening is large. For this reason, if the warpage amount with respect to 10 cm of length in the main surface of the composite is less than 50 µm, the amount of warpage when used as a heat dissipating component or the like can be insufficient, and the purposes of the present invention may not be able to be achieved.

Additionally, the present invention relates to a method for producing the above power module comprising the silicon carbide composite, wherein the aforementioned plate-shaped composite is plastically deformed by applying a stress perpendicular to the main surface at a temperature of at least 350 °C, thereby applying warpage. Due to this operation, a plate-shaped composite having the desired amount of warpage can be easily obtained. In this case, a method of pressing the composite into a mold having internal surfaces preformed in a desired shape is highly reproducible and preferred. At a temperature less than 350 °C, the metal having aluminum as the main component in the composite will substantially not undergo plastic deformation, so the purpose of the invention will be difficult to achieve. Regarding the upper limit of the temperature, if the temperature exceeds 600 °C, a portion of the aluminum alloy may form a liquid phase and begin to flow, but when heated to a temperature at which flow occurs, deformation may undesirably occur together with solidification when cooled.

Furthermore, the thermal conductivity of the composite used according to the present invention at room temperature (25 °C) is at least 150 W/mK. When the thermal conductivity is less than 150 W/mK, there are problems in that sufficient heat dissipation properties are not obtained when used as a heat dissipating component or the like, and the possible applications are limited.

Additionally, the composite used according to the present invention has an average coefficient of thermal expansion of 9 × 10⁻⁶/K or less when heated from room temperature (25 °C) to 150 °C. If the average coefficient of thermal expansion when heated from room temperature (25 °C) to 150 °C exceeds 9 × 10⁻⁶/K, when used as a heat dissipating component in a power module or the like, the difference in the coefficient of thermal expansion with respect to the ceramic substrate becomes too large, and problems such as cracking or breaking of the ceramic substrate may occur due to the load from thermal cycling and thermal joining, and the possible applications are limited when used as a heat dissipating component requiring reliability.

Additionally, the composite used according to the present invention has a density of about 3 g/cm³, which is light compared to metals such as copper, and when used as a heat dissipating component or the like, is effective in reducing the weight of components. On the other hand, the composite used according to the present invention has a high bending strength of at least 300 MPa, and has sufficient mechanical properties for use as a heat dissipating component or the like.

Furthermore, a heat dissipating component using the above-mentioned composite has excellent thermal conductivity properties and sufficient mechanical properties, and is suitable for use in heat sinks or the like. Additionally, the heat dissipating component is lightweight with a density of about 3 g/cm³, and is suitable as a heat dissipating component for use in mobile equipment. The heat dissipating component has excellent thermal conductivity properties, and has a low average coefficient of thermal expansion of 9 × 10⁻⁶/K or less, so when used as a heat dissipating component such as a heat sink or the like, the thermal expansion difference with ceramic substrates joined to the heat dissipating component is smaller than in the case of using conventional copper or the like, and cracking or breaking of the ceramic substrate due to thermal cycling or the like that occurs when operating a semiconductor device on the substrate can be suppressed. Due thereto, it is suitable as a heat dissipating component for use in mobile equipment such as electric automobiles or the like requiring high reliability.

Additionally, with the integration and increased size of semiconductor devices, the ceramic substrates on which they are mounted are required to have high heat dissipating properties. Aluminum nitride and silicon carbide substrates have excellent insulation properties and excellent heat dissipation properties, so that by using them by joining them to the heat dissipating component, high reliability can be obtained with extremely little cracking or breaking due to thermal cycling or the like.

Additionally, the heat dissipating plate has the characteristic that at least 90% of the surface is in close contact when a surface to which a ceramic substrate is not joined is mounted on a flat plate with a heat dissipation grease therebetween, under conditions of at least 2 N of tightening torque, and this provides the advantage of allowing heat generated when operating semiconductor devices on a ceramic substrate to be quickly dissipated, and allowing a highly reliable module to be formed.

A method for manufacturing the composite used according to the present invention involves adding and mixing a predetermined amount of a silica sol and/or an alumina sol or the like as a binding agent in a silicon carbide powder, and molding to a desired shape. The molding method may be dry press molding, wet press molding, extrusion molding, cast molding or the like, and a shape-retaining binder may be added as needed. Additionally, regarding the silicon carbide powder, one type of powder may be used, but it is even more preferable to blend a plurality of powders of appropriate grain size, since this allows a high density molded article to be easily obtained. Next, the resulting molded article is calcined at a temperature of 700 to 1600 °C in air or in an inert gas atmosphere such as nitrogen to produce a silicon carbide porous body. On the other hand, a similar production method may be used by adding and mixing a silicon powder as a binder to the silicon carbide powder. Furthermore, with regard to the production method of the silicon carbide porous body, it can be produced by baking a silicon carbide powder or a mixed powder of silicon powder and carbon powder at a temperature of 1600 to 2200 °C in an inert gas atmosphere.

The resulting silicon carbide porous body, after processing to a predetermined shape, is preheated in order to prevent cracking or the like due to thermal shock, and impregnated at a high pressure with molten metal having aluminum as the main component, heated to a temperature of at least the melting point, to form a composite. In order to adjust the thickness of the metal layer on the surface of the composite, when processing the silicon carbide porous body, grooves or the like may be added to the surface portion so as to adjust the thickness of the alloy layer on the surface of the composite obtained by impregnation. Additionally, it can be adjusted by laminating a thin plate of Al alloy onto the surface of the silicon carbide porous body and impregnating. In this case, not only a porous body, but also a silicon carbide powder may be used. Furthermore, the thickness of the metal layer on the surface of the composite can be adjusted by mechanically processing the metal layer on the surface of the composite. Furthermore, by making use of a die or the like, a preform of a slightly smaller size than the size of a cavity in the die can be provided inside the cavity, and the molten metal injected into the cavity inside the die.

Regarding the impregnation method of the metal component, there are no particular limitations, and high-pressure casting, die casting or the like may be used.

### EXAMPLES

Herebelow, the present invention will be explained in further detail by providing examples and comparative examples, but the present invention is not to be construed as being limited thereto.

### [Examples 1-8, Comparative Examples 1-4]

Silicon carbide powder A (manufactured by Pacific Rundum: NG-150, average particle size 100 µm), silicon carbide powder B (manufactured by Yakushima Denko: GC-1000F, average particle size 10 µm) and a silica sol (manufactured by Nissan Chemical Industries: Snowtex) were blended in a composition at a mass ratio of 60 : 40 : 10, mixed for 1 hour in a stirrer/mixer, then molded at a pressure of 10 MPa to a shape of 187 mm × 137 mm × 7 mm. Thereafter, the molded article was heated for 2 hours at 960 °C in air to produce a silicon carbide porous body. The resulting silicon carbide porous body was processed to a shape of 20 mmφ × 7 mm, and upon calculating the relative density based on the dimensions and the mass, a value of 65% was obtained.

Next, the resulting silicon carbide porous body was processed to a desired thickness using a diamond processing tool, twelve of the samples were separated by 0.8 mm thick SUS plates coated with a mold release agent, and 12 mm thick iron plates were provided on both ends, after which they were fastened using 10 mmφ bolts and nuts to form a single block.

Next, two of the aforementioned blocks were used as one block which was preheated to a temperature of 650 °C in an electric furnace, and placed inside a preheated press mold having a cavity with internal dimensions of 320 mm × 260 mm × 440 mm, after which a melt of an aluminum alloy (ADC-12) heated to a temperature of 810 °C was poured in and pressed for at least 13 minutes at a pressure of 500 MPa to impregnate the silicon carbide porous body with the aluminum metal. The resulting metal ingot containing the composite was cooled to room temperature and cut with a wet band saw to release the silicon carbide composite.

For the resulting composite, the top and bottom positions in the thickness direction of the composite were sensed by a laser using a laser thickness measuring device (manufactured by Keyence; VT2-10SB) to measure the thickness at the five points shown in Fig. 2, the average thickness of the composite was calculated from the average value thereof, and the thickness variation was determined from the maximum value and the minimum value. Additionally, after the surface of the composite was polished using a roll polisher to remove altered layers of the composite surface, a laser three-dimensional shape measuring device (manufactured by Keyence: LK-GD500) was used to illuminate the object with a laser beam, the light that was diffused and reflected from the object was received to calculate the amount of displacement, and the amount of warpage of the main surface of the composite was measured. The warpage amounts (Cx, Cy) of the main surface of the composite were measured for power modules using each of the composites, by means of a laser three-dimensional shape measuring device. The results are shown in Table 1.

**[Table 1]**

| Type | Thickness of Composite (t) | Thickness Variation of Composite | Composite | | Power Module | |
|---|---|---|---|---|---|---|
| | | | Cx | Cy | Cx | Cy |
| | (mm) | (mm) | (µm) | (µm) | (µm) | (µm) |
| Example 1 | 2.0 | ±0.1 | 60 | 60 | 50 | 60 |
| Example 2 | 3.0 | ±0.1 | 100 | 100 | 90 | 70 |
| Example 3 | 4.0 | ±0.2 | 170 | 130 | 160 | 110 |
| Example 4 | 5.0 | ±0.2 | 130 | 70 | 90 | 60 |
| Example 5 | 5.0 | ±0.3 | 100 | 70 | 100 | 60 |
| Example 6 | 5.0 | ±0.2 | 120 | 130 | 110 | 100 |
| Example 7 | 5.0 | ±0.3 | 160 | 160 | 150 | 150 |
| Example 8 | 6.0 | ±0.3 | 140 | 130 | 90 | 90 |
| Comparative Example 1 | 1.0 | ±0.2 | -30 | 270 | 0 | 260 |
| Comparative Example 2 | 7.0 | ±0.2 | 100 | 0 | 0 | -20 |
| Comparative Example 3 | 4.0 | ±0.4 | 100 | -100 | 50 | -50 |
| Comparative Example 4 | 5.0 | ±0.5 | -100 | 20 | -50 | 0 |

| | | | | | | |
|---|---|---|---|---|---|---|
| Cx, Cy: Warpage amount with respect to 10 cm sample length | | | | | | |

Additionally, from the resulting composite, a diamond processing tool was used to grind a test sample for measurement of coefficient of thermal expansion (4 × 4 × 20 mm), a test sample for measurement of thermal conductivity at room temperature (25 mm × 25 mm × 1 mm), and a test sample for measurement of three-point bending strength (3 mm × 30 mm × thickness). Additionally, using a portion of the test sample for measurement of three-point bending strength, the cross section was observed under a microscope, and the thicknesses of the front and back metal layers of the composite were measured at nine locations and the average thickness was calculated. The results are shown in Table 2.

**[Table 2]**

| Type | Average Thickness (µm) of Metal Layer | | |
|---|---|---|---|
| | Front | Back | Difference |
| Example 1 | 90 | 80 | 10 |
| Example 2 | 30 | 60 | 30 |
| Example 3 | 50 | 40 | 10 |
| Example 4 | 50 | 40 | 10 |
| Example 5 | 60 | 30 | 30 |
| Example 6 | 70 | 80 | 10 |
| Example 7 | 50 | 50 | 0 |
| Example 8 | 40 | 20 | 20 |
| Comparative Example 1 | 150 | 100 | 50 |
| Comparative Example 2 | 10 | 5 | 5 |
| Comparative Example 3 | 200 | 80 | 120 |
| Comparative Example 4 | 350 | 50 | 300 |

Next, using each of the test samples, the coefficient of thermal expansion from room temperature to 250 °C was measured using a thermal expansion meter, the thermal conductivity at room temperature was measured by a laser flash method, and the three-point bending strength was measured using a bend testing machine. Furthermore, the densities of the composites were calculated from the dimensions and weights of the samples for measurement of thermal conductivity. The results are shown in Table 3.

**[Table 3]**

| Type | Coefficient of Thermal Expansion (10⁻⁶/K) | Thermal Conductivity (W/mK) | Three-point Bending Strength (MPa) | Density (g/cm³) |
|---|---|---|---|---|
| Example 1 | 6.4 | 190 | 410 | 2.98 |
| Example 2 | 6.9 | 225 | 350 | 2.98 |
| Example 3 | 7.4 | 210 | 420 | 2.99 |
| Example 4 | 7.2 | 220 | 400 | 2.98 |
| Example 5 | 7.7 | 225 | 410 | 2.98 |
| Example 6 | 7.4 | 230 | 400 | 2.98 |
| Example 7 | 7.5 | 230 | 360 | 2.98 |
| Example 8 | 7.3 | 205 | 400 | 2.97 |
| Comparative Example 1 | 11.0 | 140 | 100 | 2.75 |
| Comparative Example 2 | 10.5 | 210 | 400 | 2.98 |
| Comparative Example 3 | 10.3 | 200 | 410 | 2.99 |
| Comparative Example 4 | 10.2 | 205 | 390 | 2.98 |

Additionally, for various composites obtained by the aforementioned operations, one side was coated with silicon grease (manufactured by Shin-etsu Chemical) weighed to have a thickness of 50 µm, then attached to an acrylic plate with a thickness of 30 mm using 6M screws with a tightening torque of 3 N. After letting stand for 1 minute, the screws were removed and the rate of close contact (proportional area) of the silicon grease-coated surface was measured. The results are shown in Table 4.

**[Table 4]**

| Type | Close Contact Rate (%) |
|---|---|
| Example 1 | 99 |
| Example 2 | 99 |
| Example 3 | 98 |
| Example 4 | 98 |
| Example 5 | 93 |
| Example 6 | 97 |
| Example 7 | 99 |
| Example 8 | 99 |
| Comparative Example 1 | 55 |
| Comparative Example 2 | 60 |
| Comparative Example 3 | 75 |
| Comparative Example 4 | 45 |

### [Examples 9 to 11]

The silicon carbide composite produced in Comparative Example 1 was set in a jig composed of SUS-304 as shown in Fig. 3, a stress perpendicular to the main surface was applied as a load using an M10 screw, after which the composite was heated for 30 minutes in an electric furnace at a temperature of 500 °C, then cooled to room temperature and freed from the load. The amount of warpage of the resulting composite is shown in Table 5. Next, the results of evaluation of the obtained composite using the same method as in Examples 1-8 are shown in Table 5. As shown in Table 5, the rate of close contact was able to be raised by forming a convex surface using a jig.

**[Table 5]**

| Type | Cx (µm) | Cy (µm) | Close Contact Rate (%) |
|---|---|---|---|
| Example 9 | 120 | 50 | 99 |
| Example 10 | 150 | 70 | 99 |
| Example 11 | 180 | 90 | 99 |

### BRIEF DESCRIPTION OF THE DRAWINGS

[Fig. 1] Plan view showing an example of a composite used according to the present invention.
[Fig. 2] Representative diagram of thickness measurement points of a composite used according to the present invention.
[Fig. 3] Explanatory diagram of a jig used in an embodiment of the present invention.

## Claims

1. A power module comprising a silicon carbide composite which is a plate-shaped composite formed by pressure impregnation of a porous silicon carbide molded article with a metal containing aluminum, the silicon carbide composite having a plate thickness t of 2 mm to 6 mm and an in-plane thickness variation within t ± 0.3 mm, having four or more hole portions for screw-fastening another heat dissipating component in the plane of the plate-shaped composite so as to face a convex surface of the plate-shaped composite, **characterized in that** an amount of warpage (Cx; µm) with respect to 10 cm of length in an inter-hole direction (X direction) and an amount of warpage (Cy; µm) with respect to 10 cm of length in a direction (Y direction) perpendicular thereto have the relationships 50 ≤ Cx ≤ 250 and 0 ≤ Cy ≤ 200, and the amounts of warpage of the composite main surface in the power module is 50 ≤ Cx ≤ 250 and 0 ≤ Cy ≤ 200.

2. The power module according to claim 1, comprising a silicon carbide composite wherein front and back surfaces are both covered by a metal layer containing aluminum having an average thickness of 10 to 110 µm, and the difference in average thickness between the front and back metal layers is 100 µm or less.

3. The power module according to claim 1, comprising a silicon carbide composite comprising a composite portion (A), and a metal layer (B) containing aluminum provided on at least one surface of the composite, wherein the ratio (TA/TB) between the average value (TA; µm) of the thickness of the plate-shaped composite (A) and the sum (TB; µm) of the average values of the thicknesses of the metal layers (B) on both surfaces is 10 to 30.

4. The power module according to claim 1 or 2, comprising a silicon carbide composite wherein the product of the maximum length (L; cm) of the composite and the absolute value (|TB1 - TB2|) of the difference between the average value (TB1; µm) of the thickness of the metal layer (B) on the front surface and the average value (TB2; µm) of the thickness thereof on the back surface is at least 500 and at most 2000.

5. The power module according to any one of claims 1 to 4, comprising a silicon carbide composite wherein the thermal conductivity at a temperature of 25 °C is at least 150 W/mK, the average coefficient of thermal expansion when heated from 25 °C to 150 °C is at most 9 × 10⁻⁶/K, the three-point bending strength at a temperature of 25 °C is 150 MPa to 500 MPa, the elasticity at a temperature of 25 °C is 150 GPa to 350 GPa, and the density is 2.8 to 3.1 g/cm³.

6. A method for manufacturing the power module according to any one of claims 1 to 5, wherein the silicon carbide composite is warped by plastic deformation by applying stress at a temperature of at least 350 °C.

7. The power module according to any one of claims 1 to 5, comprising a heat dissipating component obtained by joining, to the plate-shaped silicon carbide composite, a ceramic substrate for mounting a semiconductor.

8. The power module according to claim 7, wherein the ceramic substrate is aluminum nitride or silicon nitride.

9. The power module according to claim 7 or claim 8, comprising a heat dissipating component wherein when the surface that is not joined to the ceramic substrate for mounting a semiconductor is attached to a flat plate with a heat dissipating grease provided therebetween, at least 90% of the surface closely contacts the flat plate under conditions of a tightening torque of at least 2 N.

## Patentansprüche

1. Power-Modul, umfassend ein Silicium-Carbid-Komposit, welches ein plattenförmiges Komposit ist, gebildet durch Druckimprägnierung eines porösen Silicium-Carbid-Formkörpers mit einem Metall, enthaltend Aluminium, wobei das Silicium-Carbid-Komposit eine Plattendicke t von 2 mm bis 6 mm und eine Dickenvariation in der Ebene innerhalb von t ± 0,3 mm aufweist, mit vier oder mehr Lochbereichen zur Schraubbefestigung einer anderen wärmeverteilenden Komponente in der Ebene des plattenförmigen Komposits, um einer konvexen Oberfläche des plattenförmigen Komposits gegenüberzuliegen, **dadurch gekennzeichnet, dass** ein Ausmaß der Verformung (Cx; µm) bezüglich einer Länge von 10 cm in der Zwischenlochrichtung (X-Richtung) und ein Ausmaß der Verformung (Cy; µm) bezüglich einer Länge von 10 cm in einer Richtung (Y-Richtung) senkrecht dazu die Beziehung aufweisen: 50 ≤ Cx ≤ 250 und 0 ≤ Cy ≤ 200, und die Ausmaße der Verformung der Komposithauptoberfläche in dem Power-Modul sind: 50 ≤ Cx ≤ 250 und 0 ≤ Cy ≤ 200.

2. Power-Modul nach Anspruch 1, umfassend ein Silicium-Carbid-Komposit, wobei vordere und hintere Oberflächen beide überzogen sind mit einer Metallschicht, enthaltend Aluminium, mit einer durchschnittlichen Dicke von 10 bis 110 µm und wobei die Differenz in der durchschnittlichen Dicke zwischen den vorderen und hinteren Metallschichten 100 µm oder weniger beträgt.

3. Power-Modul nach Anspruch 1, umfassend ein Silicium-Carbid-Komposit, umfassend einen Kompositanteil (A) und eine Metallschicht (B), enthaltend Aluminium, aufgebracht auf mindestens eine Oberfläche des Komposits, wobei das Verhältnis (TA/TB) zwischen dem Durchschnittswert (TA; µm) der Dicke des plattenförmigen Komposits (A) und der Summe (TB; µm) des durchschnittlichen Werts der Dicke der Metallschicht (B) auf beiden Oberflächen 10 bis 30 beträgt.

4. Power-Modul nach Anspruch 1 oder 2, umfassend ein Silicium-Carbid-Komposit, wobei das Produkt der maximalen Länge (L; cm) des Komposits und des absoluten Werts (|TB1 - TB2|) der Differenz zwischen dem durchschnittlichen Wert (TB1; µm) der Dicke der Metallschicht (B) an der vorderen Oberfläche und des durchschnittlichen Werts (TB2; µm) der Dicke davon an der hinteren Oberfläche mindestens 500 und höchstens 2000 beträgt.

5. Power-Modul nach einem der Ansprüche 1 bis 4, umfassend ein Silicium-Carbid-Komposit, wobei die thermische Leitfähigkeit bei einer Temperatur von 25°C mindestens 150 W/mK beträgt, der durchschnittliche Koeffizient der thermischen Ausdehnung bei Erwärmung von 25°C auf 150°C höchstens 9 × 10⁻⁶/K beträgt, die Drei-Punkt-Biegungsfestigkeit bei einer Temperatur von 25°C 150 MPa bis 500 MPa beträgt, die Elastizität bei einer Temperatur von 25°C 150 GPa bis 350 GPa beträgt und die Dichte 2,8 bis 3,1 g/cm³ beträgt.

6. Verfahren zur Herstellung des Power-Moduls nach einem der Ansprüche 1 bis 5, wobei das Silicium-Carbid-Komposit verformt wird durch plastische Verformung durch Anwenden einer Spannung bei einer Temperatur von mindestens 350°C.

7. Power-Modul nach einem der Ansprüche 1 bis 5, umfassend eine wärmeverteilende Komponente, erhalten durch Verbinden, mit dem plattenförmigen Silicium-Carbid-Komposit, eines keramischen Substrats zur Befestigung eines Halbleiters.

8. Power-Modul nach Anspruch 7, wobei das keramische Substrat Aluminiumnitrid oder Siliciumnitrid ist.

9. Power-Modul nach Anspruch 7 oder Anspruch 8, umfassend eine wärmeverteilende Komponente, wobei, wenn die Oberfläche die nicht mit dem keramischen Substrat zur Befestigung eines Halbleiters verbunden ist, mit einer flachen Platte mit einem wärmeleitenden Fett dazwischen befestigt ist, mindestens 90% der Oberfläche mit der flachen Platte in engem Kontakt steht, und zwar unter den Bedingungen eines Befestigungsdrehmoments von mindestens 2 N.

## Revendications

1. Module de puissance comprenant un composite de carbure de silicium qui est un composite en forme de plaque formé par imprégnation sous pression d'un article moulé de carbure de silicium poreux avec un métal contenant de l'aluminium, le composite de carbure de silicium ayant une épaisseur de plaque t de 2 mm à 6 mm et une variation d'épaisseur dans le plan dans les t ± 0,3 mm, ayant quatre ou plus de parties perforées pour la fixation par vissage d'un autre composant de dissipation de chaleur dans le plan du composite en forme de plaque de façon à se trouver en regard d'une surface convexe du composite en forme de plaque, **caractérisé en ce qu'**une quantité de voilement (Cx ; µm) par rapport à 10 cm de longueur dans une direction entre trous (direction X) et une quantité de voilement (Cy ; µm) par rapport à 10 cm de longueur dans une direction (direction Y) qui lui est perpendiculaire présentent les relations 50 ≤ Cx ≤ 250 et 0 ≤ Cy ≤ 200 et les quantités de voilement de la surface principale du composite dans le module de puissance sont de 50 ≤ Cx ≤ 250 et 0 ≤ Cy ≤ 200.

2. Module de puissance selon la revendication 1, comprenant un composite de carbure de silicium, dans lequel les surfaces avant et arrière sont toutes deux couvertes d'une couche métallique contenant de l'aluminium ayant une épaisseur moyenne de 10 à 110 µm et la différence d'épaisseur moyenne entre les couches métalliques avant et arrière est de 100 µm ou moins.

3. Module de puissance selon la revendication 1, comprenant un composite de carbure de silicium comprenant une partie composite (A) et une couche métallique (B) contenant de l'aluminium appliquée sur au moins une surface du composite, dans lequel le rapport (TA/TB) entre la valeur moyenne (TA ; µm) de l'épaisseur du composite en forme de plaque (A) et la somme (TB ; µm) des valeurs moyennes des épaisseurs des couches métalliques (B) sur les deux surfaces est de 10 à 30.

4. Module de puissance selon la revendication 1 ou 2, comprenant un composite de carbure de silicium, dans lequel le produit de la longueur maximale (L ; cm) du composite et de la valeur absolue (|TB1 - TB2|) de la différence entre la valeur moyenne (TB1 ; µm) de l'épaisseur de la couche métallique (B) sur la surface avant et la valeur moyenne (TB2 ; µm) de son épaisseur sur la surface arrière est au moins de 500 et au maximum de 2 000.

5. Module de puissance selon l'une quelconque des revendications 1 à 4, comprenant un composite de carbure de silicium, dans lequel la conductibilité thermique à une température de 25 °C est d'au moins 150 W/mK, le coefficient moyen d'expansion thermique lorsque l'on chauffe de 25 °C à 150 °C est au maximum de 9 x 10⁻⁶/K, la résistance à la flexion en trois points à une température de 25 °C est de 150 MPa à 500 MPa, l'élasticité à une température de 25 °C est de 150 GPa à 350 GPa et la masse volumique est de 2,8 à 3,1 g/cm³.

6. Procédé de fabrication du module de puissance selon l'une quelconque des revendications 1 à 5, dans lequel le composite de carbure de silicium est voilé par déformation plastique en appliquant une contrainte à une température d'au moins 350 °C.

7. Module de puissance selon l'une quelconque des revendications 1 à 5, comprenant un composant de dissipation thermique obtenu en joignant au composite de carbure de silicium en forme de plaque un substrat de céramique pour monter un semi-conducteur.

8. Module de puissance selon la revendication 7, dans lequel le substrat de céramique est du nitrure d'aluminium ou du nitrure de silicium.

9. Module de puissance selon la revendication 7 ou la revendication 8, comprenant un composant de dissipation thermique, dans lequel, lorsque la surface qui n'est pas jointe au substrat de céramique pour monter un semi-conducteur est fixée à une plaque plate avec de la graisse de dissipation thermique disposée entre elles, au moins 90 % de la surface sont en contact étroit avec la plaque plate dans des conditions d'un couple de serrage d'au moins 2 N.
